# EUROPEAN PATENT SPECIFICATION

(11) **EP 4 002 483 B1**
(45) Date of publication and mention of the grant of the patent: **21.10.2026**
(21) Application number: 19938279.7
(22) Date of filing: 20.08.2019
(51) Int. Cl.: H10D 30/47, H10D 30/01, H10D 64/23, H10D 62/85, H10D 62/852

(54) **GAN HIGH-ELECTRON-MOBILITY TRANSISTOR HAVING SPLICING SUB-DEVICE AND MANUFACTURE METHOD THEREFOR**
GAN-TRANSISTOR MIT HOHER ELEKTRONEMOBILITÄT UND SPLEISSUNTERANORDNUNG SOWIE HERSTELLUNGSVERFAHREN DAFÜR
TRANSISTOR GAN À HAUTE MOBILITÉ D'ÉLECTRONS AYANT UN DISPOSITIF SECONDAIRE D'ÉPISSAGE ET SON PROCÉDÉ DE FABRICATION

(30) Priority: 19.07.2019 CN 201910655060
(43) Date of publication of application: 25.05.2022
(73) Proprietor: China Electronics Technology Group Corporation No.55 Research Institute, Nanjing, Jiangsu 210016 (CN)
(72) Inventor: ZHANG, Kai, Nanjing, Jiangsu 210016 (CN); ZHU, Guangrun, Nanjing, Jiangsu 210016 (CN); ZHOU, Jianjun, Nanjing, Jiangsu 210016 (CN); CHEN, Tangsheng, Nanjing, Jiangsu 210016 (CN)
(74) Representative: Lorenz Seidler Gossel Part. mbB
(86) International application number: PCT/CN2019/101506
(87) International publication number: WO 2021/012340

(56) References cited:
- WO-A1-2018/103606
- CN-A- 101 252 088
- CN-A- 108 886 052
- CN-A- 109 727 862
- CN-A- 109 888 011
- JP-A- 2014 041 965
- US-A1- 2018 374 943

## Description

### TECHNICAL FIELD

The present invention relates to the technical field of manufacturing of semiconductor devices, in particular of GaN high-electron-mobility transistors having a splicing sub-device.

### BACKGROUND

With the characteristics of high output power density, high efficiency, resistance to high temperature and radiation and the like, the third-generation semiconductor GaN-based high-electron-mobility transistor (HEMT) has becomes a mainstream technology for manufacturing high-frequency, high-efficiency and high-power electronic devices, and vigorously promotes the performance improvement of weapons and equipment represented by radar. In recent years, with the booming communication sector, the needs for high-performance components are increasingly urgent; and GaN microwave and millimeter-wave devices, with an advantage of high power, have been recognized as preferred devices for future mobile communication base stations. Different from radar applications, communications impose strict requirements on the linearity of components. If the linearity of the components is insufficient, power back-off or a linearization module is often required to ensure necessary signal waveforms, which will seriously sacrifice the working efficiency of GaN devices and the whole system. On the contrary, a high linearity will lead to a more efficient utilization of frequency spectrum and a reduction in the demand for a linearization module, thereby improving the efficiency and integration of the whole system.

The transconductance (gₘ) of a traditional GaN high-electron-mobility transistor shows typical peak properties, that is, the transconductance degrades seriously under a high current, resulting in a rapid shrinkage of gain of the device under a high input power, a poor intermodulation property and a low linearity. In order to overcome such defects, the Hong Kong University of Science and Technology put forward an Al_{0.05}Ga_{0.95}N/GaN composite channel in 2005, in which the transconductance linearity is improved to a certain degree by reducing a longitudinal electric field of the channel (references: Jie Liu et al, Highly Linear Al0.3Ga0.7N-Al0.05Ga0.95N-GaN Composite-Channel HEMTs, IEEE Electron Device Lett., vol. 26, no. 3, pp. 145-147, 2005). In addition to the degradation of the transconductance after peaking, the rising rate of the transconductance before peaking is also an important factor restraining the device linearity. Since the device is often biased to class AB in real work, the linear property in such an area is more important. gₘ' and gₘ" respectively refer to the derivative and second derivative of the transconductance and are important parameters for measuring the device linearity. The smaller gₘ' and gₘ", the higher linearity. A steep rise of the transconductance leads to large values of gₘ' and gₘ" and thus a poorer linearity. In 2016, MIT studied the linearity performance of a GaN radio-frequency circuit through a physical device model (references: Ujwal Radhakrishna et al., Study of RF-Circuit Linearity Performance of GaN HEMT Technology using the MVSG compact device model IEDM Tech. Dig., Dec. 2016, pp. 3.7.1-3.7.4), in which a dual-bias-based transconductance compensation solution is proposed, that is, gₘ' and gₘ" in the transconductance rising area are reduced to improve the linearity of the circuit while maintaining a high working efficiency.

Chinese patent application 201611122851.9 discloses "HIGH-LINEARITY GAN FIN-TYPE HIGH-ELECTRON-MOBILITY TRANSISTOR AND MANUFACTURING METHOD THEREOF". The solution involves a GaN-based three-dimensional fin-type device, in which GaN-based three-dimensional fins in periodic arrangement are etched on a barrier layer and a buffer layer in an area below a gate groove, and the length of the GaN-based three-dimensional fins is equal to the length of the groove. The solution overcomes the degradation of the transconductance after peaking in traditional plane structures by use of a three-dimensional fin-type structure, so that the gₘ' and gₘ" in the area approach to zero to present a flat transconductance property, thereby inhibiting signal distortion, improving the linearity and maintaining a high working efficiency and a good heat dissipation property. However, the transistor of this solution cannot improve the linearity of the transconductance in the rising area and inhibit the gₘ' and gₘ" in the area, and thus, the overall linearity of the device still needs further improvement.

US 2018/374943 A1 discloses a GaN HEMT with three sub-devices sharing the same buffer layer and the same gate.

At present, how to overcome the shortcomings of the prior art has become one of the key difficulties to be urgently solved in the technical field of manufacturing of semiconductor devices.

### SUMMARY

An objective of the present invention is to provide a manufacturing method for a GaN high-electron-mobility transistor having a splicing sub-device to overcome the shortcomings of the prior art. The present invention can inhibit a serious degradation of transconductance under a large current as well as the steep degree of a rising area of the transconductance, and thus improves the device linearity more comprehensively without sacrificing the frequency property of the device, and is applicable to the millimeter-wave frequency bands.

A manufacturing method for the GaN high-electron-mobility transistor having a splicing sub-device provided by the present invention and the preferred solutions, comprising the steps as in claim 1

Principles of implementing the present invention: on the basis of an initial GaN heterojunction epitaxial material (including a buffer layer and a barrier layer), and through a selective epitaxial technology (including mask growth, lithography and etching the mask, a GaN layer regrowth and mask removal), two different GaN heterojunction materials are grown on the two sides of the initial heterojunction material respectively, and then, sub-devices are prepared on the three heterojunction materials (including the initial heterojunction material and the two selective-growth heterojunction materials) with the same preparation process (including the source, the drain, the gate, etc.). Through reasonable selection of two new heterojunction materials, the threshold voltage of the splicing sub-device prepared on one of the two selective-growth heterojunction materials is greater than or equal to the threshold voltage of the sub-device on the initial heterojunction material while the threshold voltage of the splicing sub-device manufactured on the other one is less than or equal to the threshold voltage of the sub-device on the initial heterojunction material, but the threshold voltages of the two splicing sub-devices are unequal. Finally, the gates located on the three heterojunction materials (including the initial heterojunction material and the two selective-growth heterojunction materials) are electrically connected to form a device. The present invention puts forward a concept of "splicing sub-device" where the voltage range when the sub-device is started is enlarged by use of a difference in the thresholds of the splicing sub-devices, so as to alleviate the steep degree of the transconductance upon peaking, that is, gₘ' and gₘ' are inhibited, to finally achieve a purpose of improving the device linearity.

Compared with the prior art, the present invention has the following remarkable advantages:

First, the GaN high-electron-mobility transistor having a splicing sub-device provided by the present invention creatively uses a selective epitaxial technology to realize coupling of sub-devices having different threshold voltages, and restrains a sharp rise of transconductance by enlarging the voltage range when the device is started, thereby significantly improving the linearity of the device when it does not reach a power saturation state.

Second, the GaN high-electron-mobility transistor having a splicing sub-device provided by the present invention integrates three functional features of high linearity, high frequency and high power, and is applicable to the fields such as mobile communications and satellite communications, and in particular to millimeter-wave communications and broadband receiving/transmitting integrated electronic systems.

### BRIEF DESCRIPTION OF THE DRAWINGS

FIG 1 is a sectional view of the GaN high-electron-mobility transistor having a splicing sub-device which can be manufactured according to the present invention.
FIGs. 2, 3, 4, 5, 6, 7, 8, 9, 10, 11, 12, 13 and 14 are respectively a process flow diagram of the manufacturing method for the GaN high-electron-mobility transistor having a splicing sub-device according to the present invention.
FIG 15 is comparison between the transconductance (gₘ) of the GaN high-electron-mobility transistor having a splicing sub-device which can be manufactured according to the present invention and the transconductance (gₘ) of a conventional GaN high-electron-mobility transistor.
FIG 16 is comparison between the second derivative (gₘ") of the transconductance of the GaN high-electron-mobility transistor having a splicing sub-device which can be manufactured according to the present invention and the second derivative (gₘ") of the transconductance of a conventional GaN high-electron-mobility transistor.

### DETAILED DESCRIPTION OF THE EMBODIMENTS

Specific implementations of the present invention are further elaborated below in conjunction with drawings and embodiments.

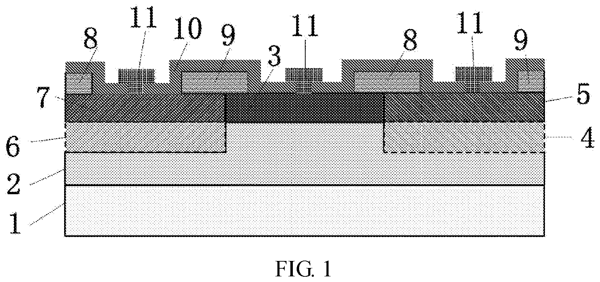

Referring to FIG 1, the present invention provides a manufacturing method for a GaN high-electron-mobility transistor having a splicing sub-device, including a substrate 1, a buffer layer 2, a barrier layer 3, a source 8, a drain 9, a passivation layer 10 and a gate 11, where the buffer layer 2 and the barrier layer 3 form a first heterojunction shaped in convex of a sub-device, and both sides of a convex step of the first heterojunction are respectively and symmetrically provided of a second heterojunction selection area with a splicing sub-device and a third heterojunction selection area of a splicing sub-device opposite each other; the second heterojunction selection area is composed of a second selective epitaxial buffer layer 4 and a second selective epitaxial barrier layer 5; the third heterojunction selection area is composed of a third selective epitaxial buffer layer 6 and a third selective epitaxial barrier layer 7; the gate 11 is located above the barrier layer 3, the second selective epitaxial barrier layer 5 and the third selective epitaxial barrier layer 7 respectively; the source 8 and the drain 9 are located on the two sides of the gate 11 respectively; the threshold voltage of the splicing sub-device located on the second heterojunction selection area is greater than or equal to the threshold voltage of the sub-device located on the first heterojunction, the threshold voltage of the splicing sub-device located on the third heterojunction selection area is less than or equal to the threshold voltage of the sub-device located on the first heterojunction, and the threshold voltages of the splicing sub-devices located on the second heterojunction selection area and the third heterojunction selection area are unequal.

The material of the barrier layer 3, the second selective epitaxial barrier layer 5 or the third selective epitaxial barrier layer 7 is AlGaN, InAlN, AlInGaN or AIN.

The material of the buffer layer 2, the second selective epitaxial buffer layer 4 or the third selective epitaxial buffer layer 6 is one of GaN and AlGaN, or a combination of the two.

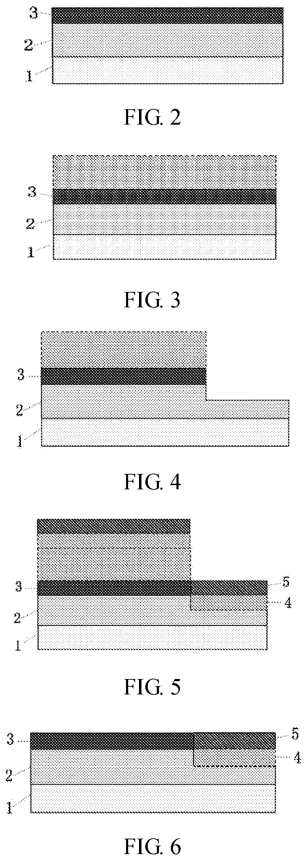

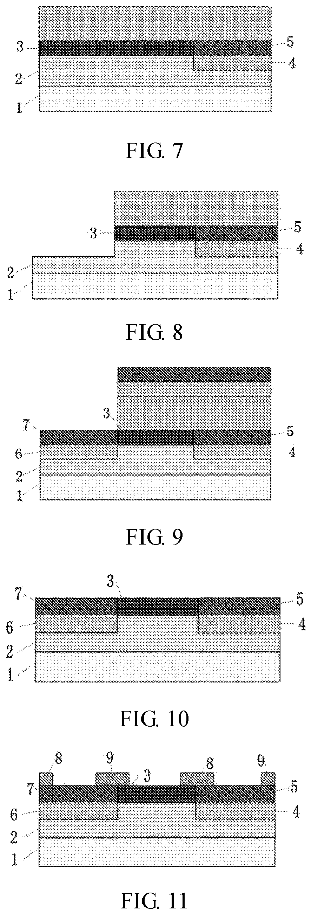

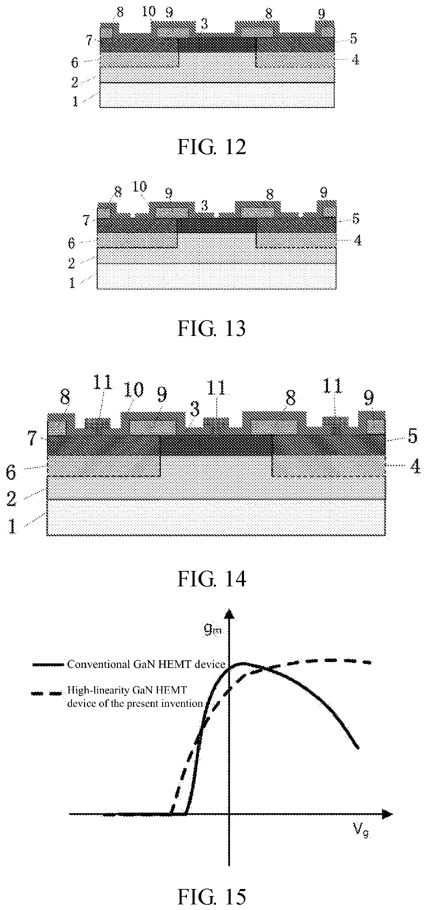

Referring to FIGs. 2-14, the present invention provides a manufacturing method for the GaN high-electron-mobility transistor having a splicing sub-device, including the following specific steps:
1) sequentially growing a buffer layer 2 and a barrier layer 3 above a substrate 1, as shown in FIG 2, where the material of the substrate 1 is any one of SiC, Si, diamond and GaN;
2) depositing a selective growth mask above the barrier layer 3, as shown in FIG 3, spin-coating a photoresist and photoetching a pattern, then sequentially removing the selective growth mask, the barrier layer 3 and a part of the buffer layer 2 by means of dry etching or wet etching, as shown in FIG 4, and then removing the photoresist, where the material of the selective growth mask is any one of SiN, SiON, SiO₂ and Ni, or a combination thereof;
3) sequentially growing a second selective epitaxial buffer layer 4 and a second selective epitaxial barrier layer 5 with an epitaxial apparatus for group III nitrides, as shown in FIG 5, and then removing the selective growth mask and the epitaxial materials thereabove by means of wet etching, as shown in FIG 6, where the epitaxial apparatus for group III nitrides is any one of metal-organic chemical vapor deposition (MOCVD), molecular beam epitaxy (MBE) and pulsed laser deposition (PLD);
4) depositing a selective growth mask above the barrier layer 3 on the left of the second selective epitaxial buffer layer 4 and the second selective epitaxial barrier layer 5, as shown in FIG 7, spin-coating a photoresist and photoetching a pattern, then sequentially removing the selective growth mask, the barrier layer 3 and a part of the buffer layer 2 by means of dry etching or wet etching, as shown in FIG 8, and then removing the photoresist, where the material of the selective growth mask is any one of SiN, SiON, SiO₂ and Ni, or a combination thereof;
5) sequentially growing a third selective epitaxial buffer layer 6 and a third selective epitaxial barrier layer 7 with an epitaxial apparatus for group III nitrides, as shown in FIG 9, and then removing the selective growth mask and the epitaxial materials thereabove by means of wet etching, as shown in FIG 10, where the epitaxial apparatus for group III nitrides is any one of MOCVD, MBE and PLD;
6) preparing a photoresist mask respectively at the two ends of the barrier layer 3, the second selective epitaxial barrier layer 5 and the third selective epitaxial barrier layer 7; depositing metals by means of evaporation or sputtering; performing lift-off to form ohmic metals; and then performing thermal annealing in a N₂ atmosphere to make a source 8 and a drain 9 respectively, as shown in FIG 11;
7) depositing a passivation layer 10 above the barrier layer 3, the second selective epitaxial barrier layer 5, the third selective epitaxial barrier layer 7, the source 8 and the drain 9, as shown in FIG 12;
8) making an active-region mask above the passivation layer 10, and then performing isolation by means of etching or ion implantation, to form an active region;
9) making a gate foot mask above the passivation layer 10, and then removing the passivation layer 10 by etching through RIE or ICP, to form a gate groove, as shown in FIG 13;
10) defining a gate cap mask above the gate groove, depositing gate metals by means of evaporation or sputtering, and performing lift-off to form a T-type gate 11, as shown in FIG 14;
11) defining an interconnected-opening region mask above the source 8 and the drain 9, and removing the passivation layer 10 by etching, to form interconnected openings; and
12) defining an interconnected-metal region mask above the source 8 and the drain 9, and forming interconnected metals by the processes of evaporation and lift-off.

According to the foregoing GaN high-electron-mobility transistor having a splicing sub-device and manufacturing method therefor of the present invention, specific examples of the present invention are further disclosed below, but the present invention is not limited thereto.

Example 1: to manufacture a GaN high-electron-mobility transistor having a splicing sub-device where a substrate 1 is SiC, a barrier layer 3 is AlₓGa₁₋ₓN, x=0.28, with a thickness of 21 nm, a second selective epitaxial barrier layer 5 is Al_{y}Ga_{1-y}N, y=0.28, with a thickness of 15 nm, and a third selective epitaxial barrier layer 7 is Al_{z}Ga_{1-z}N, z=0.28, with a thickness of 28 nm, by a manufacturing process:
1) a 2 µm unintentionally-doped GaN layer was grown on a SiC substrate 1 at 950°C using metal organic chemical vapor deposition (MOCVD) technology, to form a buffer layer 2, and then an AlGaN barrier layer 3 with a thickness of 21 nm was grown on the buffer layer 2, the Al component being 28%;
2) a selective growth mask SiO₂ was deposited above the barrier layer 3, a photoresist was spin-coated, and a pattern was etched; then, the SiO₂, the Al_{0.28}Ga_{0.72}N barrier layer 3 and the 2 µm GaN buffer layer 2 were sequentially removed by dry etching, and then the photoresist was removed, where the process conditions for depositing SiO₂ were: PECVD apparatus, gases of SiH₄, NO₂, He and N₂ respectively, flow rates of 20 sccm, 6 sccm, 100 sccm and 100 sccm respectively, a pressure of 200 mTorr, a temperature of 250°C, a power of 25 W, and a thickness of 200 nm; the process conditions for etching SiO₂ were: RIE, a gas of SF₄, a flow rate of 30 sccm, a pressure of 0.2 pa, and a power of 120 W; and the process conditions for etching AlₓGa₁₋ₓN and GaN were: gases of BCl₃ and Cl₂ respectively, flow rates of 30 sccm and 5 sccm respectively, a pressure of 30 mTorr, a temperature of 25°C, an upper electrode power of 100 W, and a lower electrode power of 3 W;
3) a 2 µm GaN second selective epitaxial buffer layer 4 and a 15 nm Al_{0.28}Ga_{0.72}N second selective epitaxial barrier layer 5 were sequentially grown at 1,030°C using a MOCVD apparatus, and then the selective growth mask and the epitaxial materials thereabove were removed with HF acid;
4) a selective growth mask SiO₂ was deposited above the barrier layer 3 on the left of the second selective epitaxial barrier layer 5, a photoresist was spin-coated, and a pattern was etched; then, the SiO₂, the Al_{0.28}Ga_{0.72}N barrier layer 3 and the 2 µm GaN buffer layer 2 were sequentially removed by dry etching, and then the photoresist was removed, where the process conditions for depositing SiO₂ were: PECVD apparatus, gases of SiH₄, NO₂, He and N₂ respectively, flow rates of 20 sccm, 6 sccm, 100 sccm and 100 sccm respectively, a pressure of 200 mTorr, a temperature of 250°C, a power of 25 W, and a thickness of 200 nm; the process conditions for etching SiO₂ were: RIE, a gas of SF₄, a flow rate of 30 sccm, a pressure of 0.2 pa, and a power of 120 W; and the process conditions for etching AlₓGa₁₋ₓN and GaN were: gases of BCl₃ and Cl₂ respectively, flow rates of 30 sccm and 5 sccm respectively, a pressure of 30 mTorr, a temperature of 25°C, an upper electrode power of 100 W, and a lower electrode power of 3 W;
5) a 2 µm GaN third selective epitaxial buffer layer 6 and a 28 nm Al_{0.28}Ga_{0.72}N third selective epitaxial barrier layer 7 were sequentially grown at 1,030°C using a MOCVD apparatus, and then the selective growth mask and the epitaxial materials thereabove were removed with HF acid;
6) a photoresist mask was prepared at the two ends of the barrier layer 3, the second selective epitaxial barrier layer 5 and the third selective epitaxial barrier layer 7 respectively; laminated metals were deposited through electron beam evaporation; lift-off was performed to form ohmic metals; then, thermal annealing was performed in a N₂ atmosphere to make a source 8 and a drain 9 respectively, where the materials of the deposited laminated metals were Ti, Al, Ni and Au sequentially from bottom to top, and the thicknesses of the deposited laminated metals were 22 nm, 170 nm, 30 nm and 40 nm respectively; the process conditions of the electron beam evaporation were: a vacuum degree ≤ 2.0×10⁻⁶ Torr, and a deposition rate less than 3 Å/s; and the process conditions of rapid thermal annealing were: a temperature of 845°C, and a time of 30 s;
7) SiN was deposited above the barrier layer 3, the second selective epitaxial barrier layer 5, the third selective epitaxial barrier layer 7, the source 8 and the drain 9 by means of PECVD to form a passivation layer 8, where the process conditions for depositing SiN were: gases of SiH₄, NH₃, He and N₂ respectively, flow rates of 8 sccm, 3 sccm, 150 sccm and 200 sccm respectively, a pressure of 300 mTorr, a temperature of 340°C, a power of 25 W, and a thickness of 100 nm;
8) an active-region mask was made above the passivation layer 10, and then isolation was performed by means of ion implantation, to form an active region, where the process conditions of the ion implantation were: B⁺ ions, a current of 6 µA, an energy of 120 KeV, and a dose of 4 e14;
9) a gate foot mask was made above the passivation layer 10, and then the passivation layer 10 was removed by etching through RIE, to form a gate groove, where the process conditions of the RIE etching were: a gas of CF₄, a flow rate of 30 sccm, a pressure of 0.5 pa, and a power of 5 W;
10) a gate cap mask was defined above the gate groove, laminated gate metals were deposited through electron beam evaporation, and lift-off was performed to form a T-type gate 11, where the process conditions for depositing the laminated metals were: a vacuum degree ≤ 2.0×10⁻⁶ Torr, and a deposition rate less than 3 Å/s; the materials of the deposited laminated metals were Ni, Au and Ni sequentially from bottom to top; and the thicknesses of the deposited laminated metals were 30 nm, 500 nm and 20 nm respectively;
11) an interconnected-opening region mask was defined above the source 8 and the drain 9, and the passivation layer 10 was removed by RIE etching, to form interconnected openings, where the process conditions of the RIE etching were: a gas of CF₄, a flow rate of 30 sccm, a pressure of 0.2 pa, and a power of 20 W; and
12) an interconnected-metal region mask was defined above the source 8 and the drain 9, and interconnected metals were formed by the processes of evaporation and lift-off, where the process conditions for depositing the metals were: a vacuum degree ≤ 1.5×10⁻⁶ Torr, and a deposition rate less than 4 Å/s; the materials of the deposited laminated metals were Ti and Au sequentially from bottom to top; and the thicknesses of the deposited laminated metals were 20 nm and 600 nm respectively.

Example 2: to manufacture a GaN high-electron-mobility transistor having a splicing sub-device where a substrate 1 is Si, a buffer layer 2 is GaN, a barrier layer 3 is AlₓGa₁₋ₓN, x=0.28, with a thickness of 12 nm, a second selective epitaxial barrier layer 5 is Al_{y}Ga_{1-y}N, y=0.20, with a thickness of 12 nm, and a third selective epitaxial barrier layer 7 is Al_{z}Ga_{1-z}N, z=0.87, with a thickness of 10 nm, by a manufacturing process:
1) a 2 µm unintentionally-doped GaN layer was grown on a Si substrate 1 at 950°C using metal organic chemical vapor deposition (MOCVD) technology, to form a buffer layer 2, and then an AlGaN barrier layer 3 with a thickness of 12 nm was grown on the buffer layer 2, the Al component being 28%;
2) a selective growth mask SiN was deposited above the barrier layer 3, a photoresist was spin-coated, and a pattern was etched; then, the SiN, the Al_{0.28}Ga_{0.72}N barrier layer 3 and the 0.3 µm GaN buffer layer 2 were sequentially removed by dry etching, and then the photoresist was removed, where the process conditions for depositing SiN were: gases of SiH₄, NH₃, He and N₂ respectively, flow rates of 8 sccm, 3 sccm, 150 sccm and 200 sccm respectively, a pressure of 300 mTorr, a temperature of 340°C, a power of 25 W, and a thickness of 200 nm; the process conditions for etching SiN were: RIE, a gas of CF₄, a flow rate of 30 sccm, a pressure of 0.2 pa, and a power of 20W; and the process conditions for etching AlₓGa₁₋ₓN and GaN were: gases of BCl₃ and Cl₂ respectively, flow rates of 30 sccm and 5 sccm respectively, a pressure of 30 mTorr, a temperature of 25°C, an upper electrode power of 100 W, and a lower electrode power of 3 W;
3) a 0.3 µm GaN second selective epitaxial buffer layer 4 and a 12 nm Al_{0.2}Ga_{0.8}N second selective epitaxial barrier layer 5 were sequentially grown at 750°C using a molecular bean epitaxy apparatus, and then the selective growth mask and the epitaxial materials thereabove were removed with HF acid;
4) a selective growth mask SiN was deposited above the barrier layer 3 on the left of the second selective epitaxial barrier layer 5, a photoresist was spin-coated, and a pattern was etched; then, the SiN, the Al_{0.28}Ga_{0.72}N barrier layer 3 and the 0.3 µm GaN buffer layer 2 were sequentially removed by dry etching, and then the photoresist was removed, where the process conditions for depositing SiN were: gases of SiH₄, NH₃, He and N₂ respectively, flow rates of 8 sccm, 3 sccm, 150 sccm and 200 sccm respectively, a pressure of 300 mTorr, a temperature of 340°C, a power of 25 W, and a thickness of 200 nm; the process conditions for etching SiN were: RIE, a gas of CF₄, a flow rate of 30 sccm, a pressure of 0.2 pa, and a power of 20 W; and the process conditions for etching AlₓGa₁₋ₓN and GaN were: gases of BCl₃ and Cl₂ respectively, flow rates of 30 sccm and 5 sccm respectively, a pressure of 30 mTorr, a temperature of 25°C, an upper electrode power of 100 W, and a lower electrode power of 3 W;
5) a 0.3 µm GaN third selective epitaxial buffer layer 6 and a 10 nm Al_{0.87}Ga_{0.13}N third selective epitaxial barrier layer 7 were sequentially grown at 750°C using a molecular beam epitaxy apparatus, and then the selective growth mask and the epitaxial materials thereabove were removed with HF acid;
6) a photoresist mask was prepared at the two ends of the barrier layer 3, the second selective epitaxial barrier layer 5 and the third selective epitaxial barrier layer 7 respectively; laminated metals were deposited through electron beam evaporation; lift-off was performed to form ohmic metals; then, thermal annealing was performed in a N₂ atmosphere to make a source 8 and a drain 9 respectively, where the deposited metals were Ti, Al and TiN from bottom to top, with thicknesses of 20 nm, 50 nm and 150 nm respectively; the process conditions of the electron beam evaporation were: a vacuum degree ≤ 2.0×10⁻⁶ Torr, and a deposition rate less than 3 Å/s; and the process conditions of rapid thermal annealing were: a temperature of 550°C, and a time of 60 s;
7) step 7) of Example 2 was the same as that of Example 1;
8) step 8) of Example 2 was the same as that of Example 1;
9) step 9) of Example 2 was the same as that of Example 1;
10) a gate cap mask was defined above the gate groove, laminated gate metals were deposited through electron beam evaporation, and lift-off was performed to form a T-type gate 11, where the process conditions for depositing the laminated metals were: a vacuum degree ≤ 1.5×10⁻⁶ Torr, and a deposition rate less than 4 Å/s; the deposited laminated metals were TiN, Ti, Al and Ti from bottom to top, with thicknesses of 20 nm, 30 nm, 500 nm and 30 nm respectively;
11) step 11) of Example 2 was the same as that of as Example 1; and
12) an interconnected-metal region mask was defined above the source 8 and the drain 9, and interconnected metals were formed by the processes of evaporation and lift-off, where the process conditions for depositing the metals were: a vacuum degree ≤ 2.0×10⁻⁶ Torr, and a deposition rate less than 4 Å/s; the materials of the deposited laminated metals were Ti, Al and Ti sequentially from bottom to top; and the thicknesses of the deposited laminated metals were 20 nm, 600 nm and 30 nm respectively.

A comparison between the transconductance (gm) of the GaN high-electron-mobility transistor having a splicing sub-device provided by the present invention and the transconductance (gₘ) of a conventional GaN high-electron-mobility transistor is shown in FIG 15. The transconductance of the conventional GaN high-electron-mobility transistor has a spike phenomenon and degrades quickly after peaking, while the transconductance of the GaN high-electron-mobility transistor having a splicing sub-device provided by the present invention rises slowly with an increasing gate voltage and does not degrade.

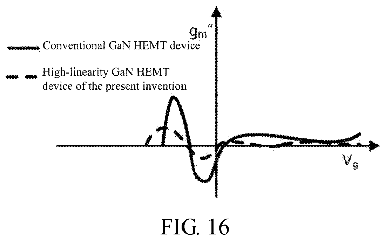

A comparison between the second derivative (gₘ") of the transconductance of the GaN high-electron-mobility transistor having a splicing sub-device provided by the present invention and the second derivative (gₘ") of the transconductance of the conventional GaN high-electron-mobility transistor is shown in FIG 16. The absolute value of the second derivative (gₘ") of the transconductance of the GaN high-electron-mobility transistor having a splicing sub-device provided by the present invention is less than the absolute value of the second derivative (gₘ") of the transconductance of the conventional GaN high-electron-mobility transistor, indicating that the GaN high-electron-mobility transistor having a splicing sub-device provided by the present invention has a higher linearity.

## Claims

1. A manufacturing method for a high-linearity GaN high-electron-mobility transistor, comprising the following steps:
1) sequentially growing a buffer layer (2) and a barrier layer (3) forming a first heterojunction above a substrate (1);
2) depositing a selective growth mask above the barrier layer (3), spin-coating a photoresist and photoetching a pattern, then sequentially removing in a second heterojunction selection area the selective growth mask and the barrier layer (3) by means of dry etching or wet etching, and over-etching to the buffer layer (2) and then removing the photoresist;
3) sequentially growing in the second heterojunction selection area a second selective epitaxial buffer layer (4) and a second selective epitaxial barrier layer (5) with an epitaxial apparatus for group III nitrides, and then removing the selective growth mask and epitaxial materials thereabove by means of wet etching;
4) depositing a selective growth mask above the barrier layer (3) on the left of the second selective epitaxial buffer layer (4) and the second selective epitaxial barrier layer (5), and above the second selective epitaxial barrier layer, spin-coating a photoresist and photoetching a pattern, then sequentially removing in a third heterojunction selection area the selective growth mask and the barrier layer (3) by means of dry etching or wet etching, and over-etching to the buffer layer (2) and then removing the photoresist, wherein the first heterojunction remains between the second heterojunction selection area and the third heterojunction selection area;
5) sequentially growing in the third heterojunction selection area a third selective epitaxial buffer layer (6) and a third selective epitaxial barrier layer (7) with the epitaxial apparatus for group III nitrides, and then removing the selective growth mask and the epitaxial materials thereabove by means of wet etching;
6) preparing a photoresist mask on respective parts of the barrier layer (3), the second selective epitaxial barrier layer (5) and the third selective epitaxial barrier layer (7); depositing metals by means of evaporation or sputtering; performing lift-off to form ohmic metals on two respective ends of the barrier layer, the second selective epitaxial barrier layer and the third selective epitaxial barrier layer, said ends being arranged along a direction along which the third heterojunction selection area, the remaining first heterojunction, and the second heterojunction selection area are arranged; and then performing thermal annealing in a N₂ atmosphere to make a source (8) and a drain (9) respectively;
7) depositing a passivation layer (10) above the barrier layer (3), the second selective epitaxial barrier layer (5), the third selective epitaxial barrier layer (7), the source (8) and the drain (9);
8) making an active-region mask above the passivation layer (10), and then performing isolation by means of etching or ion implantation, to form an active region;
9) making a gate foot mask above the passivation layer (10), and then removing the passivation layer (10) by etching through RIE or ICP, to form a gate groove on the barrier layer, the second selective epitaxial barrier layer, and the third selective epitaxial barrier layer, respectively;
10) defining a gate cap mask above the gate groove, depositing gate metals by means of evaporation or sputtering, and performing lift-off to form a T-type gate (11) on the barrier layer, the second selective epitaxial barrier layer, and the third selective epitaxial barrier layer, respectively;
11) defining an interconnected-opening region mask above the source (8) and the drain (9), and removing the passivation layer (10) by etching, to form interconnected openings; and
12) defining an interconnected-metal region mask above the source (8) and the drain (9), and forming interconnected metals by evaporation and lift-off;
wherein a threshold voltage of a sub-device located in the second heterojunction selection area is greater than or equal to the threshold voltage of a sub-device located on the remaining first heterojunction, the threshold voltage of a sub-device located in the third heterojunction selection area is less than or equal to the threshold voltage of the sub-device located on the remaining first heterojunction, and the threshold voltages of the sub-devices located in the second heterojunction selection area and the third heterojunction selection area are unequal.

2. The manufacturing method according to claim 1, wherein in step 1), a material of the substrate (1) is SiC, Si, diamond or GaN.

3. The manufacturing method for the high-linearity GaN high-electron-mobility transistor according to claim 2, wherein in steps 2) and 4), a material of the selective growth mask is any one of SiN, SiON, SiO₂ and Ni, or a combination thereof.

4. The manufacturing method according to claim 3, wherein in steps 3) and 5), the epitaxial apparatus for group III nitrides is MOCVD, MBE or PLD.

## Patentansprüche

1. Ein Herstellungsverfahren für einen GaN-Transistor mit hoher Elektronenbeweglichkeit und hoher Linearität, umfassend die folgenden Schritte:
1) sequentielles Aufwachsen einer Pufferschicht (2) und einer Barriereschicht (3), die einen ersten Heteroübergang bilden, über einem Substrat (1);
2) Abscheiden einer selektiven Wachstumsmaske über der Barriereschicht (3), Aufschleudern eines Fotolacks und Fotoätzen eines Musters, dann sequentielles Entfernen der selektiven Wachstumsmaske und der Barriereschicht (3) in einem zweiten Heteroübergangs-Auswahlbereich mittels Trockenätzen oder Nassätzen, und Überätzen bis zur Pufferschicht (2) und dann Entfernen des Fotolacks;
3) sequentielles Aufwachsen einer zweiten selektiven epitaxialen Pufferschicht (4) und einer zweiten selektiven epitaxialen Barriereschicht (5) in dem zweiten Heteroübergangs-Auswahlbereich mit einer Epitaxievorrichtung für Gruppe-III-Nitride, und dann Entfernen der selektiven Wachstumsmaske und der darauf befindlichen epitaxialen Materialien mittels Nassätzen;
4) Abscheiden einer selektiven Wachstumsmaske über der Barriereschicht (3) links von der zweiten selektiven epitaxialen Pufferschicht (4) und der zweiten selektiven epitaxialen Barriereschicht (5) und über der zweiten selektiven epitaxialen Barriereschicht, Aufschleudern eines Fotolacks und Fotoätzen eines Musters, dann sequentielles Entfernen der selektiven Wachstumsmaske und der Barriereschicht (3) in einem dritten Heteroübergangs-Auswahlbereich mittels Trockenätzen oder Nassätzen, und Überätzen bis zur Pufferschicht (2) und dann Entfernen des Fotolacks, wobei der erste Heteroübergang zwischen dem zweiten Heteroübergangs-Auswahlbereich und dem dritten Heteroübergangs-Auswahlbereich verbleibt;
5) sequentielles Aufwachsen einer dritten selektiven epitaxialen Pufferschicht (6) und einer dritten selektiven epitaxialen Barriereschicht (7) in dem dritten Heteroübergangs-Auswahlbereich mit der Epitaxievorrichtung für Gruppe-III-Nitride, und dann Entfernen der selektiven Wachstumsmaske und der darauf befindlichen epitaxialen Materialien mittels Nassätzen;
6) Herstellen einer Fotolackmaske auf jeweiligen Teilen der Barriereschicht (3), der zweiten selektiven epitaxialen Barriereschicht (5) und der dritten selektiven epitaxialen Barriereschicht (7); Abscheiden von Metallen mittels Aufdampfen oder Sputtern; Durchführen eines Lift-off-Verfahrens, um ohmsche Metalle an zwei jeweiligen Enden der Barriereschicht, der zweiten selektiven epitaxialen Barriereschicht und der dritten selektiven epitaxialen Barriereschicht zu bilden, wobei die Enden entlang einer Richtung angeordnet sind, entlang derer der dritte Heteroübergangs-Auswahlbereich, der verbleibende erste Heteroübergang und der zweite Heteroübergangs-Auswahlbereich angeordnet sind; und dann Durchführen einer thermischen Ausheilung in einer N₂-Atmosphäre, um jeweils eine Source (8) und ein Drain (9) herzustellen;
7) Abscheiden einer Passivierungsschicht (10) über der Barriereschicht (3), der zweiten selektiven epitaxialen Barriereschicht (5), der dritten selektiven epitaxialen Barriereschicht (7), der Source (8) und dem Drain (9);
8) Herstellen einer Maske für den aktiven Bereich über der Passivierungsschicht (10), und dann Durchführen einer Isolation mittels Ätzen oder Ionenimplantation, um einen aktiven Bereich zu bilden;
9) Herstellen einer Gate-Fuß-Maske über der Passivierungsschicht (10), und dann Entfernen der Passivierungsschicht (10) durch Ätzen mittels RIE oder ICP, um jeweils einen Gate-Graben auf der Barriereschicht, der zweiten selektiven epitaxialen Barriereschicht und der dritten selektiven epitaxialen Barriereschicht zu bilden;
10) Definieren einer Gate-Kappen-Maske über dem Gate-Graben, Abscheiden von Gate-Metallen mittels Aufdampfen oder Sputtern, und Durchführen eines Lift-off-Verfahrens, um jeweils ein T-förmiges Gate (11) auf der Barriereschicht, der zweiten selektiven epitaxialen Barriereschicht und der dritten selektiven epitaxialen Barriereschicht zu bilden;
11) Definieren einer Maske für den Bereich der Verbindungsöffnungen über der Source (8) und dem Drain (9), und Entfernen der Passivierungsschicht (10) durch Ätzen, um Verbindungsöffnungen zu bilden; und
12) Definieren einer Maske für den Bereich der Verbindungmetalle über der Source (8) und dem Drain (9), und Bilden von Verbindungmetallen durch Aufdampfen und Lift-off;
wobei eine Schwellenspannung einer Teilvorrichtung, die sich in dem zweiten Heteroübergangs-Auswahlbereich befindet, größer oder gleich der Schwellenspannung einer Teilvorrichtung ist, die sich auf dem verbleibenden ersten Heteroübergang befindet, die Schwellenspannung einer Teilvorrichtung, die sich in dem dritten Heteroübergangs-Auswahlbereich befindet, kleiner oder gleich der Schwellenspannung der Teilvorrichtung ist, die sich auf dem verbleibenden ersten Heteroübergang befindet, und die Schwellenspannungen der Teilvorrichtungen, die sich in dem zweiten Heteroübergangs-Auswahlbereich und dem dritten Heteroübergangs-Auswahlbereich befinden, ungleich sind.

2. Das Herstellungsverfahren nach Anspruch 1, wobei in Schritt 1) ein Material des Substrats (1) SiC, Si, Diamant oder GaN ist.

3. Das Herstellungsverfahren für den GaN-Transistor mit hoher Elektronenbeweglichkeit und hoher Linearität nach Anspruch 2, wobei in den Schritten 2) und 4) ein Material der selektiven Wachstumsmaske eines von SiN, SiON, SiO₂ und Ni oder eine Kombination davon ist.

4. Das Herstellungsverfahren nach Anspruch 3, wobei in den Schritten 3) und 5) die Epitaxievorrichtung für Gruppe-III-Nitride MOCVD, MBE oder PLD ist.

## Revendications

1. Un procédé de fabrication pour un transistor à haute mobilité d'électrons (HEMT) en GaN à haute linéarité, comprenant les étapes suivantes :
1) la croissance séquentielle d'une couche tampon (2) et d'une couche barrière (3) formant une première hétérojonction au-dessus d'un substrat (1);
2) le dépôt d'un masque de croissance sélective au-dessus de la couche barrière (3), le dépôt à la tournette d'une photorésine et la photogravure d'un motif, puis le retrait séquentiel dans une deuxième zone de sélection d'hétérojonction du masque de croissance sélective et de la couche barrière (3) au moyen d'une gravure sèche ou d'une gravure humide, et la surgravure jusqu'à la couche tampon (2) puis le retrait de la photorésine;
3) la croissance séquentielle dans la deuxième zone de sélection d'hétérojonction d'une deuxième couche tampon épitaxiale sélective (4) et d'une deuxième couche barrière épitaxiale sélective (5) avec un appareil d'épitaxie pour les nitrures du groupe III, puis le retrait du masque de croissance sélective et des matériaux épitaxiaux se trouvant au-dessus au moyen d'une gravure humide;
4) le dépôt d'un masque de croissance sélective au-dessus de la couche barrière (3) à gauche de la deuxième couche tampon épitaxiale sélective (4) et de la deuxième couche barrière épitaxiale sélective (5), et au-dessus de la deuxième couche barrière épitaxiale sélective, le dépôt à la tournette d'une photorésine et la photogravure d'un motif, puis le retrait séquentiel dans une troisième zone de sélection d'hétérojonction du masque de croissance sélective et de la couche barrière (3) au moyen d'une gravure sèche ou d'une gravure humide, et la surgravure jusqu'à la couche tampon (2) puis le retrait de la photorésine, dans lequel la première hétérojonction reste entre la deuxième zone de sélection d'hétérojonction et la troisième zone de sélection d'hétérojonction;
5) la croissance séquentielle dans la troisième zone de sélection d'hétérojonction d'une troisième couche tampon épitaxiale sélective (6) et d'une troisième couche barrière épitaxiale sélective (7) avec l'appareil d'épitaxie pour les nitrures du groupe III, puis le retrait du masque de croissance sélective et des matériaux épitaxiaux se trouvant au-dessus au moyen d'une gravure humide;
6) la préparation d'un masque de photorésine sur des parties respectives de la couche barrière (3), de la deuxième couche barrière épitaxiale sélective (5) et de la troisième couche barrière épitaxiale sélective (7); le dépôt de métaux au moyen d'une évaporation ou d'une pulvérisation cathodique; la réalisation d'un décollage (lift-off) pour former des métaux ohmiques sur deux extrémités respectives de la couche barrière, de la deuxième couche barrière épitaxiale sélective et de la troisième couche barrière épitaxiale sélective, lesdites extrémités étant agencées le long d'une direction le long de laquelle la troisième zone de sélection d'hétérojonction, la première hétérojonction restante et la deuxième zone de sélection d'hétérojonction sont agencées; puis la réalisation d'un recuit thermique dans une atmosphère de N₂ pour réaliser respectivement une source (8) et un drain (9);
7) le dépôt d'une couche de passivation (10) au-dessus de la couche barrière (3), de la deuxième couche barrière épitaxiale sélective (5), de la troisième couche barrière épitaxiale sélective (7), de la source (8) et du drain (9);
8) la réalisation d'un masque de région active au-dessus de la couche de passivation (10), puis la réalisation d'une isolation au moyen d'une gravure ou d'une implantation ionique, pour former une région active;
9) la réalisation d'un masque de pied de grille au-dessus de la couche de passivation (10), puis le retrait de la couche de passivation (10) par gravure par RIE ou ICP, pour former une rainure de grille respectivement sur la couche barrière, la deuxième couche barrière épitaxiale sélective et la troisième couche barrière épitaxiale selective;
10) la définition d'un masque de chapeau de grille au-dessus de la rainure de grille, le dépôt de métaux de grille au moyen d'une évaporation ou d'une pulvérisation cathodique, et la réalisation d'un décollage (lift-off) pour former une grille de type T (11) respectivement sur la couche barrière, la deuxième couche barrière épitaxiale sélective et la troisième couche barrière épitaxiale sélective;
11) la définition d'un masque de région d'ouvertures d'interconnexion au-dessus de la source (8) et du drain (9), et le retrait de la couche de passivation (10) par gravure, pour former des ouvertures d'interconnexion; et
12) la définition d'un masque de région de métaux d'interconnexion au-dessus de la source (8) et du drain (9), et la formation de métaux d'interconnexion par évaporation et décollage (lift-off);
dans lequel une tension de seuil d'un sous-dispositif situé dans la deuxième zone de sélection d'hétérojonction est supérieure ou égale à la tension de seuil d'un sous-dispositif situé sur la première hétérojonction restante, la tension de seuil d'un sous-dispositif situé dans la troisième zone de sélection d'hétérojonction est inférieure ou égale à la tension de seuil du sous-dispositif situé sur la première hétérojonction restante, et les tensions de seuil des sous-dispositifs situés dans la deuxième zone de sélection d'hétérojonction et la troisième zone de sélection d'hétérojonction sont inégales.

2. Le procédé de fabrication selon la revendication 1, dans lequel à l'étape 1), un matériau du substrat (1) est SiC, Si, diamant ou GaN.

3. Le procédé de fabrication pour le transistor à haute mobilité d'électrons en GaN à haute linéarité selon la revendication 2, dans lequel aux étapes 2) et 4), un matériau du masque de croissance sélective est l'un quelconque parmi SiN, SiON, SiO₂ et Ni, ou une combinaison de ceux-ci.

4. Le procédé de fabrication selon la revendication 3, dans lequel aux étapes 3) et 5), l'appareil d'épitaxie pour les nitrures du groupe III est MOCVD, MBE ou PLD.
